# EUROPEAN PATENT APPLICATION

(11) **EP 4 156 305 A1**
(43) Date of publication of application: **29.03.2023**
(21) Application number: 20936496.7
(22) Date of filing: 02.06.2020
(51) Int. Cl.: H01L 31/0224, H01L 31/05

(54) **SLURRY AND HUMID-HEAT-ATTENUATION-RESISTANT PHOTOVOLTAIC CELL**

(30) Priority: 20.05.2020 CN 202010431163
(71) Applicant: ZHEJIANG JINKO SOLAR CO., LTD., Haining, Zhejiang 314416 (CN); JINKO SOLAR CO., LTD., ShangRao, Jiangxi 334100 (CN)
(72) Inventor: YU, Kun, Haining, Zhejiang 314416 (CN); LIU, Changming, Haining, Zhejiang 314416 (CN); ZHANG, Xinyu, Haining, Zhejiang 314416 (CN); GAO, Beibei, Haining, Zhejiang 314416 (CN); MA, Zengzhi, Haining, Zhejiang 314416 (CN)
(74) Representative: Müller Schupfner & Partner Patent- und Rechtsanwaltspartnerschaft mbB
(86) International application number: PCT/CN2020/093897
(87) International publication number: WO 2021/232491

(57) **Abstract**

A paste and a damp-heat (DH) attenuation resistant photovoltaic cell. The paste comprises a paste body, into which an inert metal element and an oxide thereof are added, so that a barrier layer having a certain thickness can be formed on the surface of an electrode after sintering, and the barrier layer can resist oxidation and corrosion so as to enhance the oxidation resistance and the acid corrosion resistance of the metallized electrode. The electrode of the photovoltaic cell is made of the paste, and the DH attenuation resistant photovoltaic cell made of the paste can reduce DH attenuation and power loss, and has the enhanced environmental protection property and reliability.

## Description

This application claims priority to Chinese Patent Application No. 202010431163.0, entitled "PASTE AND DAMP-HEAT ATTENUATION RESISTANT PHOTOVOLTAIC CELL" and filed with the China Patent Office on May 20, 2020, the entire content of which is incorporated herein by reference.

### TECHNICAL FIELD

The present disclosure belongs to the technical field of photovoltaic devices, and in particular, to a paste and a damp-heat (DH) attenuation resistant photovoltaic cell.

### BACKGROUND

In the field of photovoltaic technologies, when a photovoltaic module has been operated in an outdoor environment for a long time, especially in a high-temperature and high-humidity environment, packaging materials of the photovoltaic module may gradually age, resulting in corrosion of internal metal components, which is mainly reflected in electrochemical corrosion of a solder strip and a metallized electrode of a photovoltaic cell, leading to poor electrical performance and greater power attenuation of the photovoltaic module. Temperature and humidity are the two most important factors affecting degradation of the performance of the photovoltaic module. A crystalline silicon photovoltaic module may be prone to corrosion, delamination, fading, and other failure phenomena under the action of temperature and humidity. Compared with a single-sided solar cell, a double-sided solar cell lacks protection of an aluminum back surface field, and a water-humidity rejection rate is reduced, easily leading to rather large DH attenuation. Due to a standard potential difference between metal elements in the solder strip and elements in an electrode of the photovoltaic cell, electrochemical corrosion is easily formed in a certain microenvironment. Due to long-term exposure to a damp and heat environment, the solder strip of the photovoltaic module and the metallized electrode of the photovoltaic cell may corrode, which may lead to poor electrical performance. In order to determine the performance thereof, a DH attenuation test is required. For example, in an aging test chamber of the photovoltaic module, under 85°C, 85% relative humidity (RH), and after 1000 h, if a power attenuation ratio of the photovoltaic module is less than 5%, the quality requirement is met. In the high-temperature and high-humidity environment, the photovoltaic module may undergo DH3000 or longer. If the attenuation becomes significantly larger, reliability of the quality of the photovoltaic module is required to be further enhanced.

In the related art, there is lead-free front silver paste, which can reduce corrosion of a packaging material ethylene vinyl acetate (EVA) adhesive film of the photovoltaic cell by alkaline substances in lead-free glass powder, so as to prevent the loss of the protective effect of the packaging material EVA adhesive film on the photovoltaic cell due to delamination. However, the lead-free material can be used only in a busbar of the photovoltaic cell, while a finger is in need of lead components to etch a silicon nitride passivation layer on a surface of the photovoltaic cell to form good ohmic contact with the photovoltaic cell. Moreover, a sintering temperature of the lead-free front silver paste is generally 30°C to 50°C higher than that of a leaded silver paste, which is not conducive to reducing series resistance of the photovoltaic cell. DH attenuation of the photovoltaic module is manifested by that an increase in the series resistance is associated with the finger of the photovoltaic cell. Thus, the above solution also has limitations and cannot meet the requirements on paste of the finger.

### SUMMARY

In order to solve the above problems, the present disclosure provides a paste and a DH attenuation resistant photovoltaic cell, so that a barrier layer having a certain thickness can be formed on the surface of an electrode after sintering, and the barrier layer can resist oxidation and corrosion, so as to enhance the oxidation resistance and the acid corrosion resistance of the metallized electrode.

The present disclosure provides a paste, including a paste body, the past body includes an inert metal element and an oxide thereof.

In some embodiments, the past body further includes a non-active rare-earth element fluoride.

In some embodiments, the past body further includes a non-active rare-earth element.

In some embodiments, the inert metal element is at least one of a titanium element, a platinum element, or a gold element.

In some embodiments, a mass percentage of the inert metal element is in a range of 0.01% to 1%.

In some embodiments, the non-active rare-earth element fluoride is at least one of yttrium fluoride or lanthanum fluoride.

In some embodiments, the non-active rare-earth element is at least one of an yttrium element, a lanthanum element, or a cerium element.

In some embodiments, a mass percentage of the non-active rare-earth element is in a range of 0.01% to 1%.

The present disclosure provides a DH attenuation resistant photovoltaic cell, and an electrode of the photovoltaic cell is made of the paste described as above.

In some embodiments, the electrode of the photovoltaic cell includes both a finger and a busbar.

As can be known through the above descriptions, in the paste according to the present disclosure, an inert metal element and an oxide thereof are added into the paste body, so that a barrier layer having a certain thickness can be formed on the surface of an electrode after sintering, and the barrier layer can resist oxidation and corrosion, so as to enhance the oxidation resistance and the acid corrosion resistance of the metallized electrode. The DH attenuation resistant photovoltaic cell made of the paste can reduce DH attenuation and power loss, and has the enhanced environmental protection property and reliability.

### BRIEF DESCRIPTION OF DRAWINGS

In order to better illustrate the technical solutions in the embodiments of the present disclosure or the related art, the accompanying drawings used in the description of the embodiments or the related art will be introduced below. It is apparent that, the accompanying drawings in the following description are only some embodiments of the present disclosure, and other drawings can be obtained by those of ordinary skill in the art from the provided drawings without creative efforts.

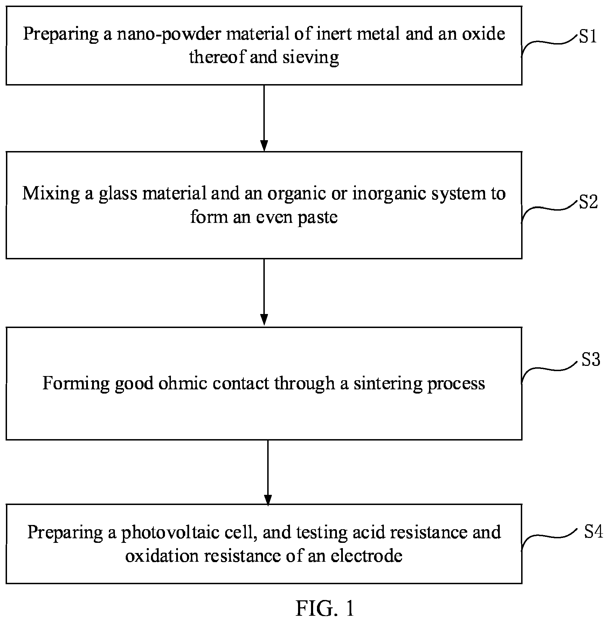

FIG. 1 is a schematic flowchart of implementation of a paste according to one or more embodiments of the present disclosure:

### DESCRIPTION OF EMBODIMENTS

The purpose of the present disclosure is to provide a paste and a DH attenuation resistant photovoltaic cell, which can enhance the oxidation resistance and the acid corrosion resistance of the metallized electrode, reduce DH attenuation and power loss, and thus enhance environmental protection property and reliability.

The technical solutions in the embodiments of the present disclosure will be described below with reference to the accompanying drawings in the embodiments of the present disclosure. It is appreciated that, the described embodiments are merely some of rather than all of the embodiments of the present disclosure. All other embodiments acquired by those skilled in the art without creative efforts based on the embodiments of the present disclosure shall fall within the protection scope of the present disclosure.

In some embodiments of the present disclosure, a paste is provided, including a paste body, into which an inert metal element and an oxide thereof are added. The inert metal used herein may be, but is not limited to, titanium, platinum, and gold. Taking titanium element as an example, after sintering, the titanium element reacts with a glass material in the paste to form a titanium oxide, so that a certain barrier layer is formed on the surface of the electrode, which can resist acid corrosion of silver and aluminum of the electrode. Titanium has good stability in acidic, alkaline, and neutral saline solutions and an oxidizing medium, and the titanium element is not easily corroded in low-concentration non-oxidizing acid. In addition to a single type of inert metal, a combination of two or more inert metals may also be used, which is not limited herein. Such inert metal elements and oxides thereof are more stable and may be sintered to form a barrier layer with a thickness between 2 microns and 5 microns on the surface of the electrode. A specific manufacturing process may be shown in FIG. 1. FIG. 1 is a schematic flowchart of implementation of a paste according to one or more embodiments of the present disclosure. The process includes the following steps.

In S1, a nano-powder material of inert metal and an oxide thereof is prepared and sieved.

Nanoparticles may have particle sizes between 15 nm and 40 nm, with excellent dispersion. Further, a preparation method for a nano-metallic material may be a physical method or a chemical method. The chemical method includes a chemical reduction method, a chemical precipitation method, a sol-gel method, a hydrothermal method, a template synthesis method, a solvothermal synthesis method, a high-temperature combustion synthesis method, an electrolysis method, and so on. The physical method is a high-energy ball milling method in some embodiments. A glass material and inorganic and organic additives can be mixed without delamination, with an advantage that an average particle size of the nanoparticles obtained is relatively small, the printing may not cause blockage to screen meshes, and printing requirements on a line width below 20 µm can be met.

In S2, a glass material and an organic or inorganic system are mixed to form an even paste.

In S3, good ohmic contact is formed by using a sintering process.

After sintering in this way, the inert metal and the oxide thereof can form a barrier layer on the surface of the electrode.

In S4, a photovoltaic cell is prepared, and acid resistance and oxidation resistance of an electrode are tested.

As can be known through the above descriptions, in the paste according to the present disclosure, an inert metal element and an oxide thereof are added into the paste body, so that a barrier layer having a certain thickness can be formed on the surface of an electrode after sintering, and the barrier layer can resist oxidation and corrosion, so as to enhance the oxidation resistance and the acid corrosion resistance of the metallized electrode.

In some embodiments of the paste, a non-active rare-earth element fluoride is further added into the paste body. The non-active rare-earth element fluoride has good acid corrosion resistance, thus reducing the corrosion of the electrode of the photovoltaic cell by acid.

In some embodiments of the paste, a non-active rare-earth element is further added into the paste body. The non-active rare-earth element may consume certain organic acid, for example, it can form complexes with citric acid, acetic acid, ammonia triacetic acid (NTA), and ethylenediamine tetraacetic acid (EDTA) to inhibit electrochemical corrosion within the electrode. Further, the non-active rare-earth element may be at least one of an yttrium element, a lanthanum element, and a cerium element. The yttrium element and the lanthanum element have good anti-sulfur and anti-oxidation effects, and can form complexes with the organic acid to reduce the corrosion of the silver-aluminum electrode by the organic acid, while the cerium element can reduce a corrosion rate of aluminum in a silver-aluminum paste, and one or more of the elements may be used, which is not limited herein.

In some embodiments of the paste, a mass percentage of the inert metal element may be in a range of 0.01% to 1%. In this case, the surface of the electrode can be protected with a lower dosage, thereby achieving the purpose of reducing the corrosion of the electrode on the basis of low costs.

In some embodiments of the paste, the non-active rare-earth element fluoride may be at least one of yttrium fluoride and lanthanum fluoride. Rare-earth fluoride and oxalate have low solubility in water and dilute inorganic acid.

In the above paste, a mass percentage of the non-active rare-earth element is in a range of 0.01% to 1%. The following solution may be adopted: the cerium element accounts for 0.005%, the yttrium element accounts for 0.002%, and the lanthanum element accounts for 0.005%.

In some embodiments of a DH attenuation resistant photovoltaic cell according to the present disclosure, an electrode of the photovoltaic cell is made of the paste according to the above embodiments. The finger of the photovoltaic cell may be made of the paste separately, or the busbar of the photovoltaic cell may be made of the paste separately, which is not limited herein. The electrode of the photovoltaic cell may also include both the finger and the busbar. In other words, the busbar and the finger of the photovoltaic cell are made of the paste at the same time. The DH attenuation resistant photovoltaic cell made of the paste can reduce DH attenuation and power loss, and achieve enhanced environmental protection property and reliability.

The above solutions and technical effects are described below with three detailed embodiments.

### Embodiment 1

A titanium element with a mass percentage in a range of 0.02% to 0.05% was added to a metallized paste and sintered to form, along with a glass material in the metallized paste, a certain amount of titanium dioxide, which covers a surface of an electrode to form a protective layer, thereby preventing reduction of power of the photovoltaic module finally caused by partial loss of the electrode, increase of series resistance, and decrease of the filling factor due to corrosion of the silver element in the electrode by acidic substances produced by decomposition of polymer materials in materials of the photovoltaic module or long-term infiltration of oxygen.

### Embodiment 2

In view of the situation that the infiltration of oxygen in the photovoltaic module and sulfide produced by decomposition of silica gel in a packaging material may cause the corrosion of silver in the paste and the loss of the electrode, 0.01% to 0.05% yttrium, lanthanum, and cerium by mass percentage were added into the metallized paste. After sintering, the rare-earth elements were diffused into the electrode and combined with silver or silver-aluminum to slow the corrosion caused by the oxygen and sulfur elements. It should be noted that the cerium element can reduce the corrosion of the aluminum element and better protect the electrode of the photovoltaic cell using a silver-aluminum paste.

### Embodiment 3

Still in view of the situation that the infiltration of oxygen in the photovoltaic module and sulfide produced by decomposition of silica gel in a packaging material may cause the corrosion of silver in the paste and the loss of the electrode, the combination of an inert metal element and a rare-earth element was added into a metallized paste, including a titanium element with a mass percentage in a range of 0.01% to 0.02%, a gold element with a mass percentage in a range of 0.005% to 0.015%, rare-earth elements yttrium and lanthanum with mass percentages in a range of 0.005% to 0.01%, and a cerium element with a mass percentage in a range of 0.005% to 0.01%. Better usage effect may be brought by combining the above two manners.

No polyolefin elastomer (POE) material or EVA containing rare-earth elements was used as the packaging material of the photovoltaic module. DH attenuation data after different periods of time was shown in Table 1:

**Table 1**

| | DH1000 attenuation | DH2000 attenuation | DH4000 attenuation |
|---|---|---|---|
| Basic solution | 3.52% | 4.78% | 9.87% |
| Embodiment 1 | 2.84% | 3.75% | 5.82% |
| Embodiment 2 | 1.94% | 3.16% | 4.41% |
| Embodiment 3 | 1.36% | 2.74% | 3.86% |

The above data shows that, after the application of the paste according to the present application, amplitude of attenuation of the photovoltaic module after a DH process is reduced.

The above descriptions of the disclosed embodiments are provided to enable those skilled in the art to implement or use the present disclosure. Various modifications to these embodiments will be readily apparent to those skilled in the art, and the generic principles defined herein may be implemented in other embodiments without departing from the scope of the present disclosure. Therefore, the present disclosure will not be limited to the embodiments shown herein, but is to conform to the broadest scope consistent with the principles and novel features disclosed herein.

## Claims

1. A paste, comprising a paste body, wherein the past body includes an inert metal element and an oxide thereof.

2. The paste according to claim 1, wherein the past body further includes a non-active rare-earth element fluoride.

3. The paste according to claim 1, wherein the past body further includes a non-active rare-earth element.

4. The paste according to claim 1, wherein the inert metal element is at least one of a titanium element, a platinum element, or a gold element.

5. The paste according to claim 4, wherein a mass percentage of the inert metal element is in a range of 0.01% to 1%.

6. The paste according to claim 2, wherein the non-active rare-earth element fluoride is at least one of yttrium fluoride or lanthanum fluoride.

7. The paste according to claim 3, wherein the non-active rare-earth element is at least one of an yttrium element, a lanthanum element, or a cerium element.

8. The paste according to claim 7, wherein a mass percentage of the non-active rare-earth element is in a range of 0.01% to 1%.

9. A damp-heat (DH) attenuation resistant photovoltaic cell, wherein an electrode of the photovoltaic cell is made of the paste according to any one of claims 1 to 8.

10. The DH attenuation resistant photovoltaic cell according to claim 9, wherein the electrode of the photovoltaic cell comprises both a finger and a busbar.
